# EUROPEAN PATENT APPLICATION

(11) **EP 2 538 463 A2**
(43) Date of publication of application: **26.12.2012**
(21) Application number: 12170165.0
(22) Date of filing: 31.05.2012
(51) Int. Cl.: H01L 35/32, H01L 35/34

(54) **Thermoelectric conversion module and method of manufacturing the same**

(30) Priority: 22.06.2011 JP 2011138653
(71) Applicant: Kabushiki Kaisha Toyota Jidoshokki, Kariya-shi, Aichi 448-8671 (JP)
(72) Inventor: Akiyama, Hirokuni, Kariya-shi, Aichi 448-8671 (JP); KATOato, Hirohisa, Kariya-shi, Aichi 448-8671 (JP); Morisaku, Naoto, Kariya-shi, Aichi 448-8671 (JP); Mune, Shimpei, Kariya-shi, Aichi 448-8671 (JP)
(74) Representative: TBK

(57) **Abstract**

The method of manufacturing a thermoelectric conversion module includes the steps of providing a first inner surface of a first substrate with plural first electrodes and a first positioning portion, wherein the first positioning portion is located at a predetermined position to the first electrodes without overlapping with the first electrodes, providing a second inner surface of a second substrate with plural second electrodes and a second positioning portion, wherein the second positioning portion is located at a predetermined position to the second electrodes without overlapping with the second electrodes, providing the first electrodes with plural thermoelectric conversion elements, positioning a spacer to the first substrate with a third positioning portion of the spacer on the first positioning portion, and providing the thermoelectric conversion elements with the second electrodes by positioning the second substrate to the spacer with the second positioning portion on a fourth positioning portion of the spacer.

## Description

### BACKGROUND OF THE INVENTION

The present invention relates to a thermoelectric conversion module including a first substrate, a second substrate and a thermoelectric conversion element provided between the first substrate and the second substrate and also to a method of manufacturing the same.

Japanese Unexamined Patent Application Publication No. 2003-51624 discloses a thermoelectric conversion module including a first substrate, a second substrate and a thermoelectric conversion element. The first substrate has a first electrode, and the second substrate has a second electrode, respectively. The thermoelectric conversion element is provided between the first substrate and the second substrate for interconnecting the first electrode and the second electrode. The first substrate has a plurality of marks according to which the thermoelectric conversion element and the second substrate are positioned with respect to the first substrate.

However, there has been a need that the thermoelectric conversion module should be improved in positioning the first substrate and the second substrate.

### SUMMARY OF THE INVENTION

In accordance with an aspect of the present invention, the method of manufacturing a thermoelectric conversion module includes the steps of providing a first substrate having a first inner surface, providing the first inner surface of the first substrate with a plurality of first electrodes and a first positioning portion, wherein the first positioning portion is located at a predetermined position relative to the first electrodes without overlapping with the first electrodes, providing a second substrate having a second inner surface, providing the second inner surface of the second substrate with a plurality of second electrodes and a second positioning portion, wherein the second positioning portion is located at a predetermined position relative to the second electrodes without overlapping with the second electrodes, providing the first electrodes of the first substrate with a plurality of thermoelectric conversion elements, providing a spacer having a third positioning portion and a fourth positioning portion, positioning the spacer to the first substrate with the third positioning portion of the spacer on the first positioning portion of the first substrate, and providing the thermoelectric conversion elements with the second electrodes of the second substrate by positioning the second substrate to the spacer with the second positioning portion of the second substrate on the fourth positioning portion of the spacer.

In accordance with another aspect of the present invention, the thermoelectric conversion module includes a first substrate, a second substrate, a spacer and a plurality of thermoelectric conversion elements. The first substrate has a first inner surface that is provided with a plurality of first electrodes and a first positioning portion. The first positioning portion is located at a predetermined position relative to the first electrodes without overlapping with the first electrodes. The second substrate has a second inner surface facing the first inner surface of the first substrate. The second inner surface of the second substrate is provided with a plurality of second electrodes and a second positioning portion. The second positioning portion is located at a predetermined position relative to the second electrodes without overlapping with the second electrodes. The spacer has a third positioning portion and a fourth positioning portion both of which are provided between the first substrate and the second substrate. The third positioning portion and the fourth positioning portion of the spacer are positioned to the first positioning portion of the first substrate and the second positioning portion of the second substrate, respectively. The thermoelectric conversion elements are provided between the first electrodes of the first substrate and the second electrodes of the second substrate.

Other aspects and advantages of the invention will become apparent from the following description, taken in conjunction with the accompanying drawings, illustrating by way of example the principles of the invention.

### BRIEF DESCRIPTION OF THE DRAWINGS

The invention together with objects and advantages thereof, may best be understood by reference to the following description of the presently preferred embodiments together with the accompanying drawings in which:
Fig. 1 is a schematic view showing a heat exchanging system having therein a thermoelectric conversion module according to an embodiment of the present invention;
Fig. 2 is a perspective view showing a thermoelectric conversion unit of the heat exchanging system of Fig. 1;
Fig. 3 is an exploded view showing the thermoelectric conversion unit of Fig. 2;
Fig. 4 is a fragmentary sectional view of the thermoelectric conversion unit as taken along the line IV-IV of Fig. 2;
Fig. 5 is a fragmentary sectional view of the thermoelectric conversion unit as taken along the line V-V of Fig. 2;
Fig. 6 is a fragmentary sectional view of the thermoelectric conversion unit as taken along the line VI-VI of Fig. 2;
Fig. 7 is an exploded top view showing an in-process thermoelectric conversion module of the thermoelectric conversion unit of Fig. 2;
Fig. 8 is a front view showing the in-process thermoelectric conversion module of Fig. 7;
Fig. 9 is a sectional view showing the in-process thermoelectric conversion module as taken along the line IX-IX of Fig. 7;
Fig. 10 is an exploded top view showing an in-process thermoelectric conversion module according to a modification of the embodiment of the present invention;
Fig. 11 is a front view showing the in-process thermoelectric conversion module of Fig. 10;
Fig. 12 is a side view showing the in-process thermoelectric conversion module of Fig. 10;
Fig. 13 is a sectional view showing the in-process thermoelectric conversion module as taken along the line XIII-XIII of Fig. 10;
Fig. 14 is an exploded top view showing an in-process thermoelectric conversion module according to another modification of the embodiment of the present invention; and
Fig. 15 is a sectional view showing the in-process thermoelectric conversion module of Fig. 14.

### DETAILED DESCRIPTION OF THE EMBODIMENTS

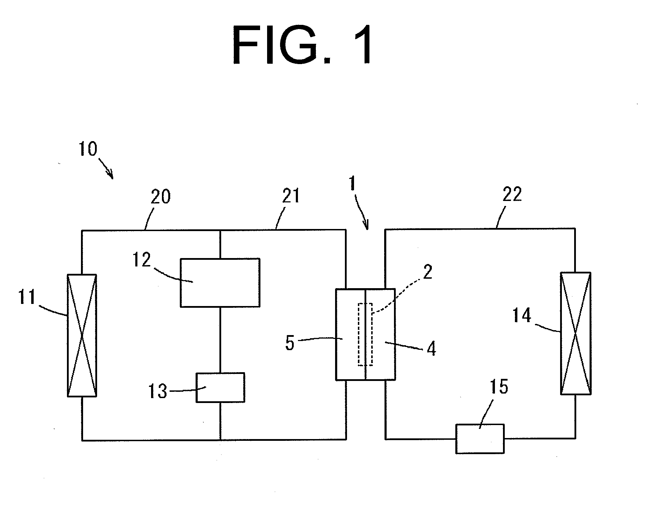

The following will describe the embodiment of the present invention with reference to Figs. 1 through 9. Referring to Fig. 1 showing the heat exchanging system 10, it is mounted to a vehicle and includes a thermoelectric conversion unit 1, a radiator 11 and a room heat exchanger 14. The radiator 11 is connected to an engine 12 of the vehicle through a tube 20. A pump 13 is connected in the tube 20 for allowing first heat medium (coolant) to circulate between the engine 12 and the radiator 11. The first heat medium absorbs heat from the engine 12 and the heat is radiated from the radiator 11 to the outside air.

The thermoelectric conversion unit 1 is connected to the radiator 11 and the engine 12 through the tube 20 and a tube 21 that is connected to the tube 20. The radiator 11 and the engine 12 are connected in parallel to each other. The first heat medium receives cold energy from the thermoelectric conversion unit 1 through the tubes 20 and 21 thereby to be cooled. Thus, the first heat medium is cooled by the thermoelectric conversion unit 1 as well as by the radiator 11.

The thermoelectric conversion unit 1 is also connected to a room heat exchanger 14 through a tube 22. A pump 15 is connected in the tube 22 for allowing second heat medium (coolant) to circulate between the thermoelectric conversion unit 1 and the room heat exchanger 14. The second heat medium absorbs heat from the thermoelectric conversion unit 1 and the heat is radiated from the room heat exchanger 14 to the air in the room of the vehicle. Thus, the air in the room of the vehicle is heated by the room heat exchanger 14.

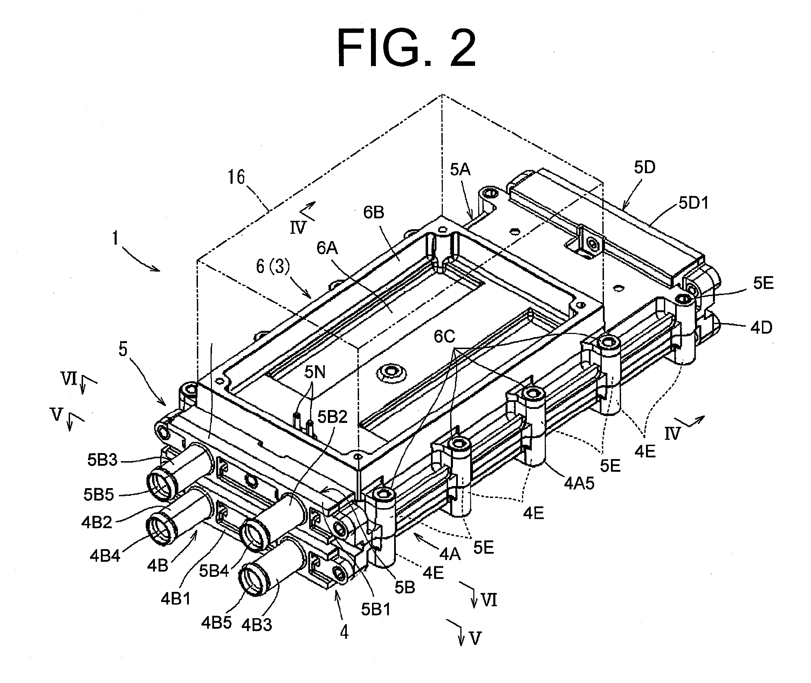

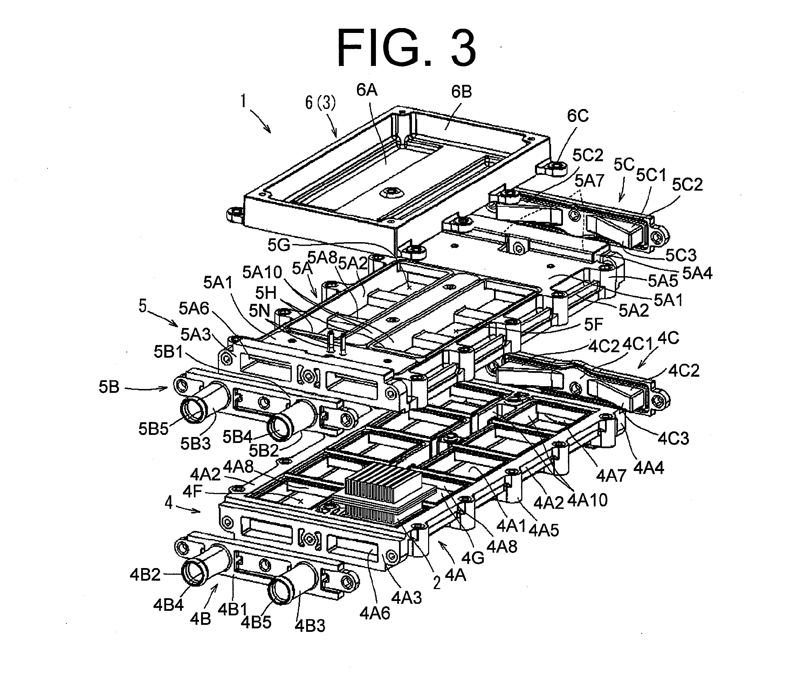

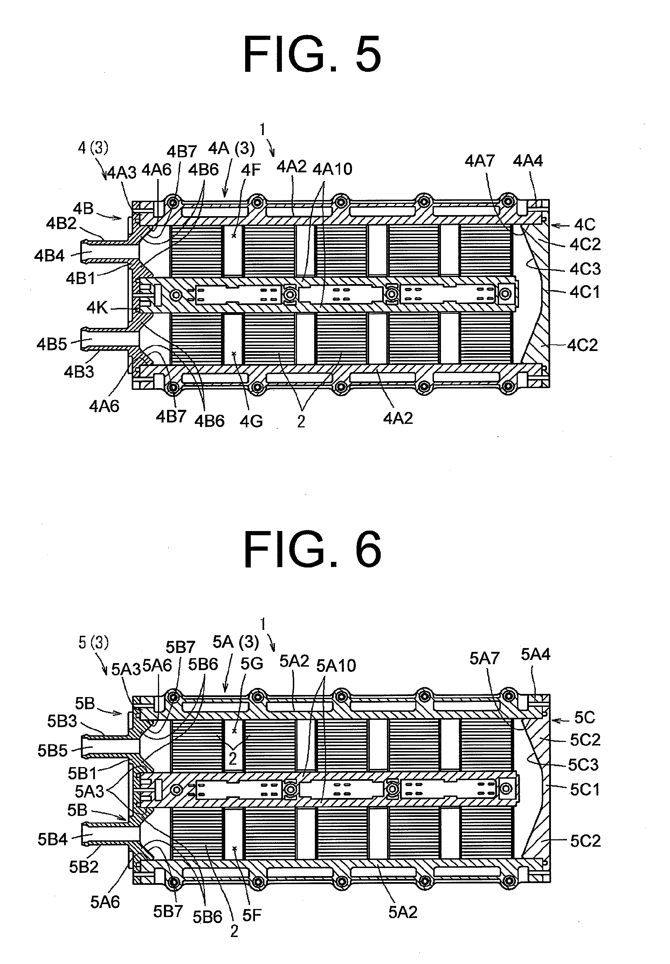

The thermoelectric conversion unit 1 includes a first case 4, a second case 5, a plurality of thermoelectric conversion modules 2 located between the first case 4 and the second case 5 as shown in Figs. 2 and 3. The first case 4 has a case body 4A, a first end member 4B and a second end member 4C, as shown in Figs. 3 and 5. The case body 4A has a bottom 4A1, sidewalls 4A2 that extend upward from the lateral ends of the bottom 4A1, a first end wall 4A3 that extends upward from the front end of the bottom 4A1 and a second end wall 4A4 that extends upward from the rear end of the bottom 4A1. The bottom 4A1 has a pair of partition plates 4A10 that extends between the first end wall 4A3 and the second end wall 4A4 for partitioning the space in the first case 4 into a plurality of fluid passages 4F and 4G extending parallel to each other.

The second case 5 has a case body 5A, a first end member 5B and a second end member 5C, as shown in Figs. 3 and 6. The case body 5A has a top 5A1, sidewalls 5A2 that extend downward from the lateral ends of the top 5A1, a first end wall 5A3 that extends downward from the front end of the top 5A1 and a second end wall 5A4 that extends downward from the rear end of the top 5A1. The top 5A1 has a pair of partition plates 5A10 that extends between the first end wall 5A3 and the second end wall 5A4 for partitioning the space in the second case 5 into a plurality of fluid passages 5F and 5G extending parallel to each other.

The case body 4A of the first case 4 has a plurality of beams 4A8 that extends between the partition plates 4A10 and the sidewalls 4A2, as shown in Figs. 3 and 5. The beams 4A8 are spaced from the bottom 4A1 so as to allow the second heat medium to flow through the fluid passages 4F and 4G. The case body 4A has a plurality of storage spaces (10 storage spaces in the present embodiment) formed by the sidewalls 4A2, the partition plates 4A10 and the beams 4A8. Similarly, the case body 5A of the second case 5 has a plurality of beams 5A8 that extends between the partition plates 5A10 and the sidewalls 5A2, as shown in Figs. 3 and 6. The beams 5A8 are spaced from the top 5A1 so as to allow the first heat medium to flow through the fluid passages 5F and 5G. The case body 5A has a plurality of storage spaces (10 storage spaces in the present embodiment) formed by the sidewalls 5A2, the partition plates 5A10 and the beams 5A8. The storage spaces of the case body 4A store the lower parts of the thermoelectric conversion modules 2, respectively, and the storage spaces of the case body 5A store the upper parts of the thermoelectric conversion modules 2, respectively.

The first end wall 4A3 of the case body 4A has openings 4A6 that are opened to the fluid passages 4F and 4G, as shown in Figs. 3 and 5. The first end member 4B is mounted to the first end wall 4A3. The second end wall 4A4 has openings 4A7 that are opened to the fluid passages 4F and 4G. The second end member 4C is mounted to the second end wall 4A4. Similarly, the first end wall 5A3 of the case body 5A has openings 5A6 that are opened to the fluid passages 5F and 5G, as shown in Figs. 3 and 6. The first end member 5B is mounted to the first end wall 5A3. The second end wall 5A4 has openings 5A7 that are opened to the fluid passages 5F and 5G. The second end member 5C is mounted to the second end wall 5A4.

The first end member 4B of the first case 4 has a mount 4B1, an inlet pipe 4B2 and an outlet pipe 4B3 fixed to the mount 4B1, as shown in Figs. 3 and 5. The mount 4B1 is provided in the form of a plate and fixed to the first end wall 4A3. The inlet pipe 4B2 and the outlet pipe 4B3 extend parallel to each other from the mount 4B1. The inlet pipe 4B2 and the mount 4B1 have an inlet passage 4B4 communicating with the fluid passage 4F. The outlet pipe 4B3 and the mount 4B1 have an outlet passage 4B5 communicating with the fluid passage 4G. Similarly, the first end member 5B of the second case 5 has a mount 5B1, an inlet pipe 5B2 and an outlet pipe 5B3 fixed to the mount 5B1, as shown in Figs. 3 and 6. The mount 5B1 is provided in the form of a plate and fixed to the first end wall 5A3. The inlet pipe 5B2 and the outlet pipe 5B3 extend parallel to each other from the mount 5B1. The inlet pipe 5B2 and the mount 5B1 have an inlet passage 5B4 communicating with the fluid passage 5F. The outlet pipe 5B3 and the mount 5B1 have an outlet passage 5B5 communicating with the fluid passage 5G.

The mount 4B1 is provided with a plurality of projections 4B6 that projects toward the case body 4A as shown in Figs. 3 and 5. The projections 4B6 are substantially triangular in cross-sectional shape as shown in Fig. 5 and fitted in the openings 4A6. The projections 4B6 have surfaces 4B7 that are inclined relative to the inlet passage 4B4 and the outlet passage 4B5, respectively, so as to form passages that are widened in cross section away from the mount 4B1. Similarly, the mount 5B1 is provided with a plurality of projections 5B6 that projects toward the case body 5A as shown in Figs. 3 and 6. The projections 5B6 are substantially triangular in cross-sectional shape as shown in Fig. 5 and fitted in the openings 5A6. The projection 5B6 have surfaces 5B7 that are inclined relative to the inlet passage 5B4 and the outlet passage 5B5, respectively, so as to form passages that are widened in cross section away from the mount 5B1.

The second end member 4C of the first case 4 has a mount 4C1 with a pair of projections 4C2, as shown in Figs. 3 and 5. The mount 4C1 is provided in the form of a plate and mounted to the second end wall 4A4. The projections 4C2 of the mount 4C1 are substantially triangular in cross-sectional shape as shown in Fig. 5 and fitted in the openings 4A7. The projections 4C2 have surfaces 4C3 that are inclined so as to form a space that is widened in cross section toward the interior of the case body 4A. Similarly, the second end member 5C of the second case 5 has a mount 5C1 with a pair of projections 5C2, as shown in Figs. 3 and 6. The mount 5C1 is provided in the form of a plate and mounted to the second end wall 5A4. The projections 5C2 of the mount 5C1 are substantially triangular in cross-sectional shape as shown in Fig. 6 and fitted in the openings 5A7. The projections 5C2 have surfaces 5C3 that are inclined so as to form a space that is widened in cross section toward the interior of the case body 5A.

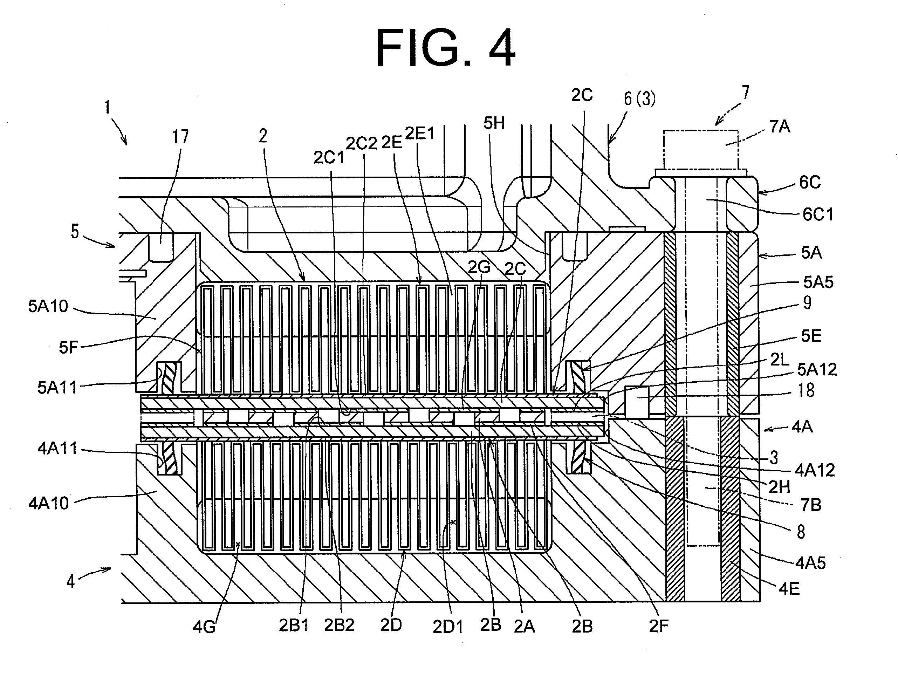

The case body 4A has a plurality of cylindrical portions 4A5 that projects outward from the sidewalls 4A2 as shown in Figs. 3 and 4. A first metal tube 4E axially extends through each cylindrical portion 4A5. Similarly, the case body 5A has a plurality of cylindrical portions 5A5 that projects outward from the sidewalls 5A2 as shown in Figs. 3 and 4. A first metal tube 5E axially extends through each cylindrical portion 5A5. The first metal tube 4E has internal threads in the inner circumferential surface thereof.

The case body 4A has in the top surface thereof a first recess 4A12 and a second recess 4A11 as shown in Fig. 4. The case body 5A has in the bottom surface thereof a first recess 5A12 and a second recess 5A11 as shown in Fig. 4. Middle part of the thermoelectric conversion module 2 (or a plurality of thermoelectric conversion elements 2A, a first substrate 2B and a second substrate 2C) is disposed in the first recesses 4A12 and 5A12. The depth of the first recesses 4A12 and 5A12 is larger than the thickness of the middle part of the thermoelectric conversion module 2. The second recess 4A11 is located alongside the outer end of the first recess 4A12 and a sealing member 8 is seated in the second recess 4A11. The second recess 5A11 is located alongside the outer end of the first recess 5A12 and a sealing member 9 is seated in the second recess 5A11.

The case body 5A also has an annular recess at a position that is radially outward of the thermoelectric conversion module 2 as shown in Fig. 4. A sealing member 18 is seated in the annular recess for sealing between the case bodies 4A and 5A. The top 5A1 of the case body 5A has a pair of openings 5H in the middle thereof as shown in Fig. 3. The openings 5H are covered by a converter case 6.

The converter case 6 is made of aluminum and has a bottom 6A and a wall 6B that extends upward from the outer end of the bottom 6A, as shown in Fig. 3. The wall 6B has a plurality of ring portions 6C that project outward. The ring portions 6C are in contact with the upper ends of the second metal tubes 5E, respectively, as shown in Fig. 4. The case body 5A has an annular recess at a position that is radially outward of each opening 5H, as shown in Fig. 4. A sealing member 17 is seated in the annular recess for sealing between the case body 5A and the converter case 6.

The cases 4, 5 and the converter case 6 are placed in this order in the thickness direction thereof and joined together by fastener members 7, as shown in Figs. 2 and 4. Each fastener member (bolt) 7 has a head portion 7A and a threaded portion 7B that is smaller in radial dimension than the head portion 7A and has an external thread in the outer circumferential surface thereof. The fastener member 7 extends through the hole 6C1 of the ring portion 6C and the second metal tube 5E and is screwed at the threaded portion 7B into the first metal tube 4E.

Each thermoelectric conversion module 2 has a first radiator fin 2D and a second radiator fin 2E, as well as the thermoelectric conversion elements 2A, the first substrate 2B and the second substrate 2C, as shown in Fig. 4. Each thermoelectric conversion element (or Peltier element) 2A has different metals, different conductors or different semiconductors. In the thermoelectric conversion element 2A which operates on the Peltier effect, heat absorption occurs on one surface of the thermoelectric conversion element 2A and heat radiation occurs on the other surface, and vice versa, when direct current is made to flow through the thermoelectric conversion element 2A. The thermoelectric conversion elements 2A are located between the first substrate 2B and the second substrate 2C.

The first substrate 2B is made of an insulating material and has a first inner surface 2B1 and a first outer surface 2B2, as shown in Figs. 3, 4 and 7. With the first outer surfaces 2B2 of the first substrates 2B covering the openings of the case 4, the first outer surfaces 2B2 and the case 4 cooperate to form the fluid passages 4F and 4G. Each first outer surface 2B2 is provided with the first radiator fin 2D. Similarly, the second substrate 2C is made of an insulating material and has a second inner surface 2C1 and a second outer surface 2C2, as shown in Figs. 3, 4 and 7. With the second outer surfaces 2C2 of the second substrates 2C covering the openings of the case 5, the second outer surfaces 2C2 and the case 5 cooperate to form the fluid passages 5F and 5G. Each second outer surface 2C2 is provided with the second radiator fin 2E.

The first radiator fin 2D extends from the first outer surface 2B2 of the first substrate 2B in a direction away from the thermoelectric conversion element 2A, as shown in Fig. 4. The first radiator fin 2D is provided by a corrugated plate and has a first space 2D1 between any two adjacent fin elements. The first radiator fin 2D is located in the fluid passages 4F and 4G so that the first spaces 2D1 extend in the longitudinal direction of the fluid passages 4F and 4G. Thus, the flow of the second heat medium through the fluid passages 4F and 4G is allowed. Similarly, the second radiator fin 2E extends from the second outer surface 2C2 of the second substrate 2C in a direction away from the thermoelectric conversion element 2A, as shown in Fig. 4. The second radiator fin 2E is provided by a corrugated plate and has a second space 2E1 between any two adjacent fin elements. The second radiator fin 2E is located in the fluid passages 5F and 5G so that the second spaces 2E1 extend in the longitudinal direction of the fluid passages 5F and 5G. Thus, the flow of the first heat medium through the fluid passages 5F and 5G is allowed.

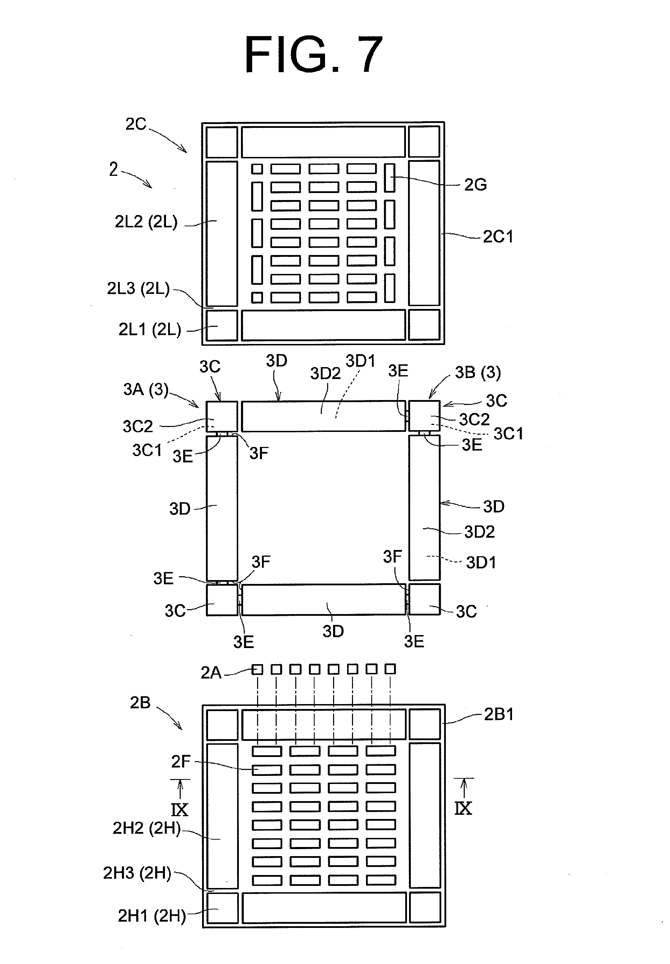

The first inner surface 2B1 of the first substrate 2B has a plurality of first electrodes 2F and a first positioning portion 2H, as shown in Fig. 7. The first electrodes 2F are made of a conductive material which is applied or bonded to the first substrate 2B. The first electrodes 2F are disposed in a central region of the first inner surface 2B1 in a lattice arrangement. Similarly, the second inner surface 2C1 of the second substrate 2C has a plurality of second electrodes 2G and a second positioning portion 2L, as shown in Fig. 7. The second electrodes 2G are made of a conductive material which is applied or bonded to the second substrate 2C. The second electrodes 2G are disposed in a central region of the second inner surface 2C1 in a lattice arrangement.

The first positioning portion 2H is in the form of a thin film, such as plated layer (or metal thin film) or solder mask (protective film), as shown in Fig. 7. The first positioning portion 2H is provided by coating, printing or brazing in an outer peripheral region of the first inner surface 2B1. The first positioning portion 2H extends from the first inner surface 2B1 of the first substrate 2B in the thickness direction thereof and is visible from lateral sides of the thermoelectric conversion module 2. Similarly, the second positioning portion 2L is in the form of a thin film, such as plated layer (or metal thin film) or solder mask (protective film), as shown in Fig. 7. The second positioning portion 2L is provided by coating, printing or brazing in an outer peripheral region of the second inner surface 2C1. The second positioning portion 2L extends from the second inner surface 2C1 of the second substrate 2C in the thickness direction thereof and is visible from lateral sides of the thermoelectric conversion module 2.

The first positioning portion 2H has four first square-shaped elements 2H1 and four second rectangular-shaped elements 2H2, as shown in Fig. 7. Each first element 2H1 is square-shaped and formed at each corner of the first substrate 2B. Each second element 2H2 is rectangular-shaped and formed between any two adjacent first elements 2H1 along the side of the first substrate 2B. Each first element 2H1 and its adjacent second element 2H2 have therebetween a slit 2H3. Similarly, the second positioning portion 2L has four first square-shaped elements 2L1 and four second rectangular-shaped elements 2L2, as shown in Fig. 7. Each first element 2L1 is square-shaped and formed at each corner of the second substrate 2C. Each second element 2H2 is rectangular-shaped and formed between any two adjacent second elements 2L1 along the side of the second substrate 2C. Each first element 2L1 and its adjacent second element 2L2 have therebetween a slit 2L3.

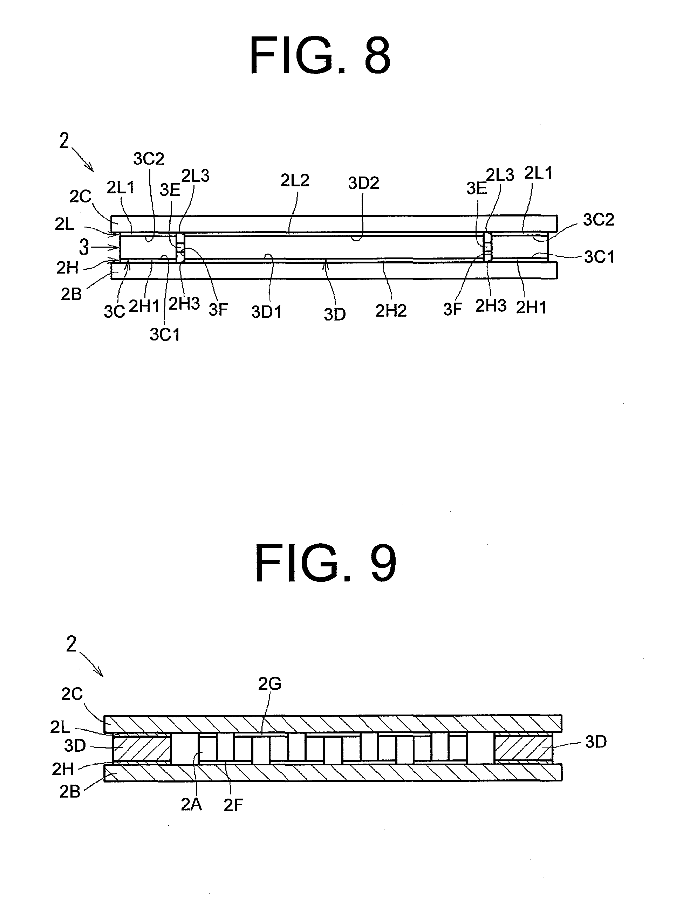

A spacer 3 is provided between the first substrate 2B and the second substrate 2C, as shown in Figs. 7 and 8. The spacer 3 serves to provide a distance between the first substrate 2B and the second substrate 2C. In the manufacturing process of the thermoelectric conversion module 2, the spacer 3 is placed between the first substrate 2B and the second substrate 2C and may be removed later. The spacer 3 has a first spacer member 3A and a second spacer member 3B. The first spacer member 3A has three corner portions 3C and two elongated portions 3D. The second spacer member 3B has one corner portion 3C and two elongated portions 3D.

As shown in Figs. 7 and 8, each corner portion 3C has a third positioning portion (or a lower surface) 3C1 in contact with the first element 2H1 of the first positioning portion 2H and a fourth positioning portion (or an upper surface) 3C2 in contact with the first element 2L1 of the second positioning portion 2L. The third positioning portion 3C1 has substantially the same shape as the first element 2H1 and the fourth positioning portion 3C2 has substantially the same shape as the first element 2L1. Each elongated portion 3D has a third positioning portion (or a lower surface) 3D1 facing the second element 2H2 of the first positioning portion 2H and a fourth positioning portion (or an upper surface) 3D2 facing the second element 2L2 of the second positioning portion 2L. The third positioning portion 3D1 has substantially the same shape as the second element 2H2 and the fourth positioning portion 3D2 has substantially the same shape as the second element 2L2. The corner portions 3C and the elongated portions 3D are of substantially the same height as or slightly higher than the thermoelectric conversion elements 2A.

As shown in Figs. 7 and 8, the corner portions 3C and the elongated portions 3D of the first spacer member 3A are connected by connecting portions 3E which are thinner than the corner portions 3C and the elongated portions 3D so that a recess 3F is formed between the corner portion 3C and the elongated portion 3D by the connecting portion 3E, as shown in Fig. 8. The corner portion 3C and the elongated portions 3D of the second spacer member 3B are connected by the connecting portions 3E so that the recess 3F is formed between the corner portion 3C and the elongated portion 3D by the connecting portion 3E. The recess 3F is formed around the connecting portion 3E and visible from lateral sides of the thermoelectric conversion module 2. The connecting portion 3E has substantially the same width as the slits 2H3 of the first positioning portion 2H and the slits 2L3 of the second positioning portion 2L.

In manufacturing the thermoelectric conversion module 2, solder paste is applied to the first electrodes 2F of the first substrate 2B and the second electrodes 2G of the second substrate 2C, as shown in Fig. 7. The first electrodes 2F of the first substrate 2B are provided with the thermoelectric conversion elements 2A. The spacer 3 is positioned to the first substrate 2B using the first positioning portion 2H.

As shown in Fig. 8, the second substrate 2C is positioned to the spacer 3 using the second positioning portion 2L. The second electrodes 2G are mounted to the thermoelectric conversion elements 2A through the solder, as shown in Fig. 9. The solder paste may be melted by heating and then solidified by cooling. Thus, the thermoelectric conversion elements 2A are connected to the first electrodes 2F and the second electrodes 2G through the solidified solder. The spacer 3 is removed from between the first substrate 2B and the second substrate 2C and then the first radiator fin 2D and the second radiator fin 2E are bonded to the first substrate 2B and the second substrate 2C, respectively, as shown in Fig. 4.

In manufacturing the thermoelectric conversion unit 1, a plurality of thermoelectric conversion modules 2 is placed in the case 4 as shown in Figs. 3 and 4. With the case 5 placed on the case 4 and also the converter case 6 placed on the case 5, the cases 4, 5 and the converter case 6 are combined together by the fastener members 7.

A converter 16 is mounted to the converter case 6, as shown in Fig. 2. The converter 16 is connected electrically to terminals 5N that extend out from the case body 4A as shown in Figs. 2 and 3. The converter 16 converts input voltage to a predetermined voltage level and supplies direct current to the terminals 5N. The direct current is supplied from the terminals 5N to each thermoelectric conversion module 2 through the electrodes of the case body 5A. The direct current flows through the thermoelectric conversion elements 2A in series by the electrodes 2F and 2G. With a current flowing through the thermoelectric conversion elements 2A, each thermoelectric conversion element 2A absorbs heat via the second substrate 2C and the second radiator fin 2E and simultaneously radiates heat via the first substrate 2B and the first radiator fin 2D.

The pump 13 (Fig. 1) supplies the first heat medium to the second case 5 via the tubes 20 and 21. The first heat medium is flowed into the fluid passages 5F and 5G via the inlet pipe 5B2 and flowed out of the fluid passages 5F and 5G via the outlet pipe 5B3 (Figs. 2 and 3). The first heat medium flowing through the fluid passages 5F and 5G is cooled by the thermoelectric conversion elements 2A via the second radiator fins 2E and the second substrates 2C (refer to Fig. 4).

The first heat medium is in contact with the converter case 6 via the opening 5H of the case body 5A as shown in Figs. 2 and 3. The first heat medium receives the heat radiated from the converter 16 via the converter case 6. Thus, the first heat medium cools the converter 16.

The pump 15 supplies the second heat medium to the first case 4 via the tube 22 (Fig. 1). The second heat medium is flowed into the fluid passages 4F and 4G via the inlet pipe 4B2 and flowed out of the fluid passages 4F and 4G via the outlet pipe 4B3 (Figs. 2 and 3). The second heat medium flowing through the fluid passages 4F and 4G is heated by the thermoelectric conversion elements 2A via the first radiator fins 2D and the first substrates 2B (refer to Fig. 4). The second heat medium flowing through the room heat exchanger 14 transfers heat to the room air (Fig. 1).

As described above and as shown in Figs. 7 through 9, the method of manufacturing the thermoelectric conversion module 2 includes the steps of providing the first substrate 2B having the first inner surface 2B1, providing the first inner surface 2B1 of the first substrate 2B with the first electrodes 2F and the first positioning portion 2H, wherein the first positioning portion 2H is located at a predetermined position relative to the first electrodes 2F without overlapping with the first electrodes 2F, providing the second substrate 2C having the second inner surface 2C1, providing the second inner surface 2C1 of the second substrate 2C with the second electrodes 2G and the second positioning portion 2L, wherein the second positioning portion 2L is located at a predetermined position relative to the second electrodes 2G without overlapping with the second electrodes 2G, providing the first electrodes 2F of the first substrate 2B with the thermoelectric conversion elements 2A, providing the spacer 3 having the third positioning portions 3C1, 3D1 and the fourth positioning portions 3C2, 3D2, positioning the spacer 3 to the first substrate 2B with the third positioning portions 3C1 and 3D1 of the spacer 3 on the first positioning portion 2H of the first substrate 2B, and providing the thermoelectric conversion elements 2A with the second electrodes 2G of the second substrate 2C by positioning the second substrate 2C to the spacer 3 with the second positioning portion 2L of the second substrate 2C on the fourth positioning portions 3C2 and 3D2 of the spacer 3.

As shown in Figs. 7 through 9, the thermoelectric conversion module 2 includes the first substrate 2B, the second substrate 2C, the spacer 3 and the thermoelectric conversion elements 2A. The first substrate 2B has the first inner surface 2B1 that is provided with the first electrodes 2F and the first positioning portion 2H. The first positioning portion 2H is located at a predetermined position relative to the first electrodes 2F without overlapping with the first electrodes 2F. The second substrate 2C has the second inner surface 2C1 facing the first inner surface 2B1 of the first substrate 2B. The second inner surface 2C1 of the second substrate 2C is provided with the second electrodes 2G and the second positioning portion 2L. The second positioning portion 2L is located at a predetermined position relative to the second electrodes 2G without overlapping with the second electrodes 2G. The spacer 3 has the third positioning portions 3C1, 3D1 and the fourth positioning portions 3C2, 3D2 all of which are provided between the first substrate 2B and the second substrate 2C. The third positioning portions 3C1, 3D1 and the fourth positioning portions 3C2, 3D2 of the spacer 3 are positioned to the first positioning portion 2H of the first substrate 2B and the second positioning portion 2L of the second substrate 2C, respectively. The thermoelectric conversion elements 2A are provided between the first electrodes 2F and the second electrodes 2G.

The relative positions of the first electrodes 2F and the first positioning portion 2H on the first substrate 2B are determined and hence hardly affected by any variation in the size of the first substrate 2B. Likewise, the relative positions of the second electrodes 2G and the second positioning portion 2L on the second substrate 2C are determined and hence hardly affected by any variation in the size of the second substrate 2C. The spacer 3 which is used to position the first substrate 2B and the second substrate 2C by the first positioning portion 2H and the second positioning portion 2L determines precisely the relative position between the first electrodes 2F and the second electrodes 2G. Thus, contact of the thermoelectric conversion elements 2A with the first electrodes 2F and the second electrodes 2G is ensured. The spacer 3 which is provided between the first substrate 2B and the second substrate 2C prevents the thermoelectric conversion elements 2A provided between the first substrate 2B and the second substrate 2C from being crushed in the process of manufacturing the thermoelectric conversion module 2.

As shown in Figs. 7 through 9, the method of manufacturing the thermoelectric conversion module 2 further includes the steps of providing solder between the first electrodes 2F of the first substrate 2B and the thermoelectric conversion elements 2A and also between the thermoelectric conversion elements 2A and the second electrodes 2G of the second substrate 2C, and melting the solder with the spacer 3 between the first substrate 2B and the second substrate 2C. Therefore, the provision of the spacer 3 prevents the spaced interval between the first substrate 2B and the second substrate 2C from reducing in melting the solder and hence prevents the thermoelectric conversion elements 2A from being crushed in the process of manufacturing the thermoelectric conversion module 2.

As shown in Figs. 7 through 9, the method of manufacturing the thermoelectric conversion module 2 further includes the step of removing the spacer 3 from between the first substrate 2B and the second substrate 2C after melting and cooling the solder. The removed spacer 3 may be used in manufacturing another thermoelectric conversion module 2.

As shown in Figs. 7 through 9, the first positioning portion 2H extends from such a position on the first inner surface 2B1 of the first substrate 2B that the first positioning portion 2H is visible from outside the thermoelectric conversion module 2. Similarly, the second positioning portion 2L extends from such a position on the second inner surface 2C1 of the second substrate 2C that the second positioning portion 2L is visible from outside the thermoelectric conversion module 2. Therefore, the first substrate 2B and the second substrate 2C may be positioned relative to the spacer 3 by visually checking from outside the thermoelectric conversion module 2.

The relative position among the substrates 2B, 2C and the spacer 3 is determined by the positioning portions 2H and 2L, as shown in Fig. 7. Even when the substrates 2B and 2C have variation in size, the relative position among the substrates 2B, 2C and the spacer 3 is determined by the positioning portions 2H and 2L with ease and precision.

At least one of the first positioning portion 2H and the second positioning portion 2L is provided by plating or resist. Therefore, the first positioning portion 2H is provided on the first substrate 2B with relative ease and/or the second positioning portion 2L is provided on the second substrate 2C with relative ease.

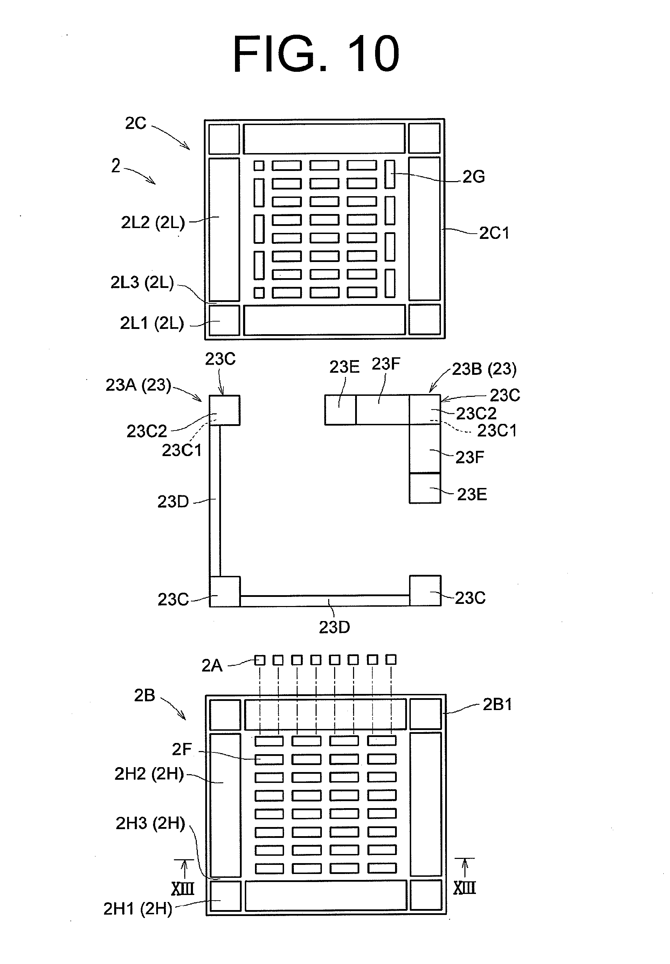

The present invention is not limited to the above-described embodiment, but it may be practiced in various manners as exemplified below. The thermoelectric conversion module 2 may have a spacer 23 shown in Figs. 10 through 13 instead of the spacer 3 shown in Fig. 7. The spacer 23 has a first spacer member 23A and a second spacer member 23B, as shown in Fig. 10. The first spacer member 23A has three corner portions 23C and two elongated portions 23D.

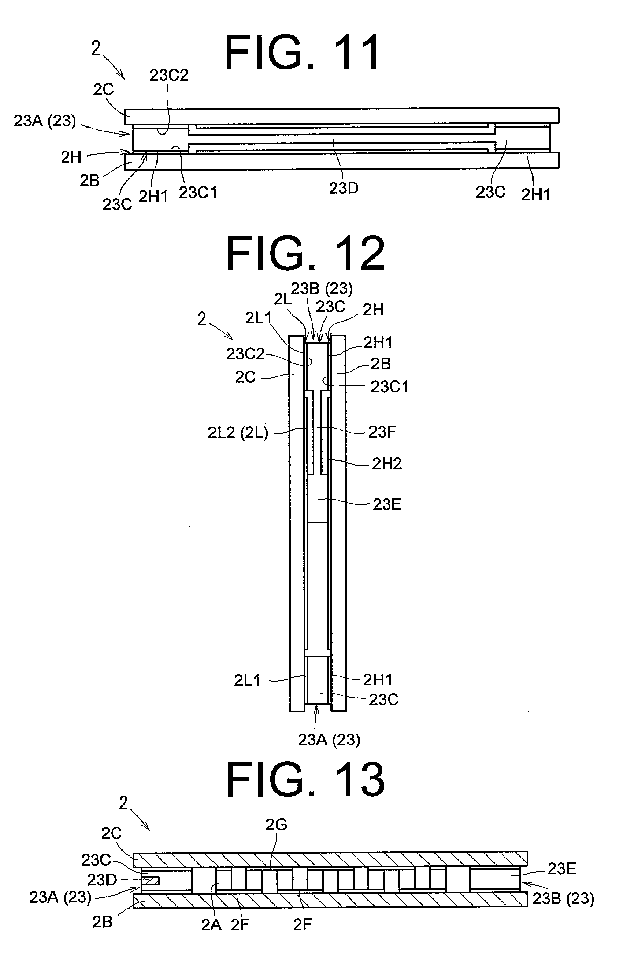

As shown in Figs. 10 and 11, each corner portion 23C has a third positioning portion (or a lower surface) 23C1 in contact with the first element 2H1 of the first positioning portion 2H and a fourth positioning portion (or an upper surface) 23C2 in contact with the first element 2L1 of the second positioning portion 2L. The third positioning portion 23C1 has substantially the same shape as the first element 2H1 and the fourth positioning portion 23C2 has substantially the same shape as the first element 2L1. The elongated portions 23D are smaller in width than the corner portions 23C, as shown in Fig. 10, and each elongated portion 23D connects the corner portions 23C at the lateral sides thereof. The elongated portions 23D are smaller in thickness than the corner portions 23C, as shown in Fig. 11 and each elongated portion 23D substantially connects the corner portions 23C at the center thereof in the direction of its thickness.

The second spacer member 23B has one corner portion 23C, two end portions 23E and two connecting portions 23F, as shown in Figs. 10 and 12. Each end portion 23E has an upper surface in contact with its corresponding second element 2L2 of the second positioning portion 2L at the middle area thereof and a lower surface in contact with its corresponding second element 2H2 of the first positioning portion 2H at the middle area thereof. The upper and lower surfaces of each end portion 23E are formed so as to correspond to the middle areas of the second elements 2L2 and 2H2, respectively. The connecting portions 23F are smaller in thickness than the corner portion 23C, as shown in Fig. 12 and each connecting portion 23F connects the corner portion 23C and the corresponding end portion 23E at the centers thereof in the thickness direction. The corner portions 23C and the end portions 23E are substantially of the same thickness or slightly thinner than the thermoelectric conversion elements 2A, as shown in Fig. 13.

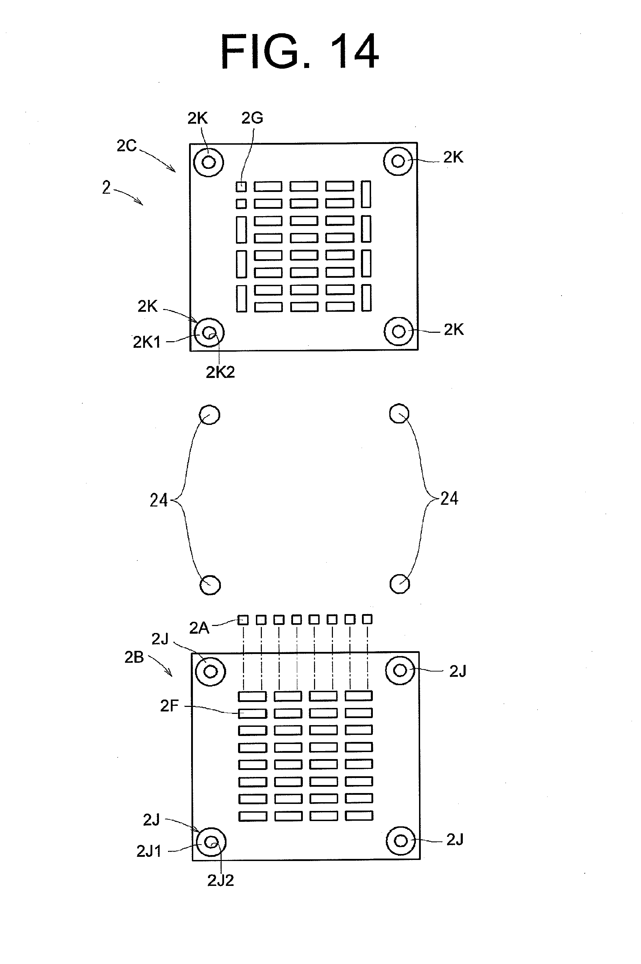

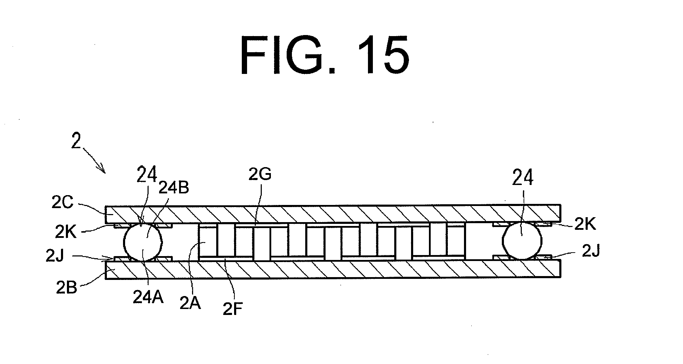

The thermoelectric conversion module 2 may include a plurality of spacers 24, a plurality of first positioning portions 2J and a plurality of second positioning portions 2K shown in Figs. 14 and 15 instead of the spacer 3, the first positioning portion 2H and the second positioning portion 2L shown in Fig. 7. The first positioning portions 2J are located adjacent to the respective corners of the first substrate 2B and the second positioning portions 2K are located adjacent to the respective corners of the second substrate 2C. The first positioning portions 2J have respective annular contact portions 2J1 and the second positioning portions 2K also have respective annular contact portions 2K1. The contact portions 2J1 extend from the first inner surface 2B1 of the first substrate 2B in the thickness direction of the first substrate 2B and the contact portions 2K1 extend from the second inner surface 2C1 of the second substrate 2C in the thickness direction of the second substrate 2C. Each contact portion 2J1 has a circular opening 2J2 at the center thereof and each contact portion 2K1 has a circular opening 2K2 at the center thereof.

Each spacer 24 is spherical in shape as shown in Figs. 14 and 15, and has a third positioning portion (curved surface) 24A and a fourth positioning portion (curved surface) 24B. The third positioning portion 24A has a surface that is curved outward toward the first substrate 2B and the fourth positioning portion 24B has a surface that is curved outward toward the second substrate 2C. The third positioning portions 24A and the fourth positioning portions 24B are placed in contact with the first positioning portions 2J and the second positioning portions 2K, respectively, thereby positioning the spacers 24 so that the centers of the curved surfaces coincide with the centers of the respective openings 2J2 and 2K2.

That is, the third positioning portions 24A and the contact portions 2J1 cooperate to form a positioning structure that determines the relative position between the spacers 24 and the first positioning portions 2J thereby to restrict the relative movement therebetween. The fourth positioning portions 24B and the contact portions 2K1 cooperate to form a positioning structure that determines the relative position between the spacers 24 and the second positioning portions 2K thereby to restrict the relative movement therebetween. The spacers 24 are of substantially the same thickness as or slightly thicker than the thermoelectric conversion elements 2A. The spacers 24 provided between the first substrate 2B and the second substrate 2C remain as a part of the thermoelectric conversion module 2.

As described above, the thermoelectric conversion module 2 shown in Figs. 14 and 15 has the positioning structure that restricts the relative movement between the first positioning portions 2J and the spacers 24 and also between the second positioning portions 2K and the spacers 24. The method of manufacturing the thermoelectric conversion module 2 includes a step of positioning the spacers 24 relative to the first substrate 2B by providing the positioning structure between the spacers 24 and the first positioning portions 2J and a step of positioning the second substrate 2C relative to the spacers 24 by providing the positioning structure between the second positioning portions 2K and the spacers 24. Therefore, the relative positions between the spacers 24 and the first substrate 2B and also between the spacers 24 and the second substrate 2C are determined with ease and precision. For example, these relative positions can be determined without any visual checking.

As shown in Figs. 14 and 15, each spacer 24 has a surface (or the third positioning portion 24A) that is curved outward toward the first substrate 2B and a surface (or the fourth positioning portion 24B) that is curved outward toward the second substrate 2C. Each first positioning portion 2J has the contact portion 2J1 that receives part of the curved surface (or the third positioning portion 24A) in contact therewith. Each second positioning portion 2K has the contact portion 2K1 that receives part of the curved surface (or the fourth positioning portion 24B) in contact therewith. The positioning structure has the curved surface (the positioning portion 24A or 24B) and the contact portion (the contact portion 2J1 or 2K1) and the curved surfaces (the positioning portions 24A and 24B) are positioned by the contact portions 2J1 are 2K1, respectively. Therefore, the spacers 24 are positioned with respect to the substrates 2B and 2C.

As shown in Figs. 14 and 15, each spacer 24 is spherical in shape and each of the contact portions 2J1 and 2K1 is formed in an annular shape. Thus, the spacers 24 are centered with respect to the first positioning portions 2J and the second positioning portions 2K, respectively, with the center of each spacer 24 coinciding with the center of annularity of the contact portions 2J1 and 2K1.

The spacer 3 shown in Fig. 7 may additionally have a grip that extends outward of the spacer 3. Such a grip facilitates the removal of the spacer 3 from between the substrates 2B and 2C. The same is true for the spacer 23 shown in Fig. 10.

The spacer 3 may be formed so as to correspond to the positioning portions 2H and 2L. The spacer 3 may have a mark such as arrow or any other patterns, at each of the positions corresponding to the positioning portions 2H and 2L. The same is true for the spacer 23.

The positioning portions 2H and 2L may be provided on the inner surfaces 2B1 and 2C1 of the substrates 2B and 2C, respectively, so as to be visible from outside the thermoelectric conversion module 2. Alternatively, the positioning portion 2H and/or 2L may be provided on the side of its or their corresponding substrates 2B and 2C so as to be visible from outside the thermoelectric conversion module 2.

The contact portion 2J1 of each positioning portion 2J may have a rectangular opening instead of the circular opening 2J2. Each positioning portion 2J may have a plurality of elements in contact with the spacer so that the elements are arranged in an annular shape or rectangular shape. The same is true for the contact portion 2K1 of each positioning portion 2K.

The spacer 24 may have two surfaces that are curved outward toward the substrates 2B and 2C, and a connecting portion that connects the two curved surfaces. The spacer 24, the positioning portions 2J and 2K may be rectangular in shape. In this case, the relative rotation between the spacer and the positioning portions, as well as the relative movement therebetween, can be prevented.

The positioning structure may be provided either between the spacers 24 and the first positioning portions 2J or between the spacers 24 and the second positioning portions 2K.

The positioning portions 2J and 2K shown in Fig. 14 may be provided so as to be visible from outside the thermoelectric conversion module 2. Alternatively, the positioning portions 2J and 2K may be provided so as to be invisible from outside the thermoelectric conversion module 2.

The positioning portions 2J and 2K shown in Fig. 14 may have contact portions that recede from the inner surfaces 2B1 and 2C1 of the substrates 2B and 2C and receive part of the spacer 24 instead of the contact portions 2J1 and 2K1 that extend outward from the substrates 2B and 2C toward the spacer 24, respectively.

Each of the thermoelectric conversion elements 2A may be a Peltier device producing the Peltier effect. Alternatively, it may be a device producing the Seebeck effect or Thomson effect.

The heat exchanging system 10 may be used for cooling the air in the room of the vehicle. In this case, the first case 4 is connected to the tube 21 and the second case 5 is connected to the tube 22. Alternatively, the heat exchanging system 10 may be used for cooling and heating the air in the room of the vehicle. The heat exchanging system 10 may be used for cooling or heating any vehicle parts such as battery. Alternatively, the heat exchanging system 10 may be used for cooling or heating any other products other than vehicle.

In the above-described embodiments wherein the third positioning portions 3C1, 3D1, 23C1, 24A are plural and the fourth positioning portions 3C2, 3D2, 23C2, 24B are plural, the third positioning portions 3C1, 3D1, 23C1, 24A may be singular and the fourth positioning portions 3C2, 3D2, 23C2, 24B may also be singular.

The method of manufacturing a thermoelectric conversion module includes the steps of providing a first inner surface of a first substrate with plural first electrodes and a first positioning portion, wherein the first positioning portion is located at a predetermined position to the first electrodes without overlapping with the first electrodes, providing a second inner surface of a second substrate with plural second electrodes and a second positioning portion, wherein the second positioning portion is located at a predetermined position to the second electrodes without overlapping with the second electrodes, providing the first electrodes with plural thermoelectric conversion elements, positioning a spacer to the first substrate with a third positioning portion of the spacer on the first positioning portion, and providing the thermoelectric conversion elements with the second electrodes by positioning the second substrate to the spacer with the second positioning portion on a fourth positioning portion of the spacer.

## Claims

1. A method of manufacturing a thermoelectric conversion module (2) comprising the steps of:
providing a first substrate (2B) having a first inner surface (2B1);
providing the first inner surface (2B1) of the first substrate (2B) with a plurality of first electrodes (2F) and a first positioning portion (2H, 2J), wherein the first positioning portion (2H, 2J) is located at a predetermined position relative to the first electrodes (2F) without overlapping with the first electrodes (2F);
providing a second substrate (2C) having a second inner surface (2C1);
providing the second inner surface (2C1) of the second substrate (2C) with a plurality of second electrodes (2G) and a second positioning portion (2L, 2K), wherein the second positioning portion (2L, 2K) is located at a predetermined position relative to the second electrodes (2G) without overlapping with the second electrodes (2G);
providing the first electrodes (2F) of the first substrate (2B) with a plurality of thermoelectric conversion elements (2A);
providing a spacer (3, 23, 24) having a third positioning portion (3C1, 3D1, 23C1, 24A) and a fourth positioning portion (3C2, 3D2, 23C2, 24B);
positioning the spacer (3, 23, 24) to the first substrate (2B) with the third positioning portion (3C1, 3D1, 23C1, 24A) of the spacer (3, 23, 24) on the first positioning portion (2H, 2J) of the first substrate (2B); and
providing the thermoelectric conversion elements (2A) with the second electrodes (2G) of the second substrate (2C) by positioning the second substrate (2C) to the spacer (3, 23, 24) with the second positioning portion (2L, 2K) of the second substrate (2C) on the fourth positioning portion (3C2, 3D2, 23C2, 24B) of the spacer (3, 23, 24).

2. The method according to claim 1, further comprising the steps of:
providing solder between the first electrodes (2F) of the first substrate (2B) and the thermoelectric conversion elements (2A) and also between the thermoelectric conversion elements (2A) and the second electrodes (2G) of the second substrate (2C); and
melting the solder with the spacer (3) between the first substrate (2B) and the second substrate (2C).

3. The method according to claim 2, further comprising the step of removing the spacer (3) from between the first substrate (2B) and the second substrate (2C) after melting and cooling the solder.

4. The method according to claim 1, further comprising the steps of:
positioning the spacer (24) relative to the first substrate (2B) by providing a positioning structure (24A, 2J1) that restricts relative movement between the spacer (24) and the first positioning portion (2J); and/or
positioning the second substrate (2C) relative to the spacer (24) by providing a positioning structure (24B, 2K1) that restricts relative movement between the second positioning portion (2K) and the spacer (24).

5. A thermoelectric conversion module (2) comprising:
a first substrate (2B) having a first inner surface (2B1) that is provided with a plurality of first electrodes (2F) and a first positioning portion (2H, 2J), wherein the first positioning portion (2H, 2J) is located at a predetermined position relative to the first electrodes (2F) without overlapping with the first electrodes (2F);
a second substrate (2C) having a second inner surface (2C1) facing the first inner surface (2B1) of the first substrate (2B), wherein the second inner surface (2C1) of the second substrate (2C) is provided with a plurality of second electrodes (2G) and a second positioning portion (2L, 2K), wherein the second positioning portion (2L, 2K) is located at a predetermined position relative to the second electrodes (2G) without overlapping with the second electrodes (2G);
a spacer (3, 23, 24) having a third positioning portion (3C1, 3D1, 23C1, 24A) and a fourth positioning portion (3C2, 3D2, 23C2, 24B) both of which are provided between the first substrate (2B) and the second substrate (2C), wherein the third positioning portion (3C1, 3D1, 23C1, 24A) and the fourth positioning portion (3C2, 3D2, 23C2, 24B) of the spacer (3, 23, 24) are positioned to the first positioning portion (2H, 2J) of the first substrate (2B) and the second positioning portion (2L, 2K) of the second substrate (2C), respectively; and
a plurality of thermoelectric conversion elements (2A) provided between the first electrodes (2F) of the first substrate (2B) and the second electrodes (2G) of the second substrate (2C).

6. The thermoelectric conversion module (2) according to claim 5, wherein the first positioning portion (2H, 2J) extends from such a position on the first inner surface (2B1) of the first substrate (2B) that the first positioning portion (2H, 2J) is visible from outside the thermoelectric conversion module (2), and/or wherein the second positioning portion (2L, 2K) extends from such a position on the second inner surface (2C1) of the second substrate (2C) that the second positioning portion (2L, 2K) is visible from outside the thermoelectric conversion module (2).

7. The thermoelectric conversion module (2) according to claim 5, wherein a positioning structure (24A, 2J1) is provided for restricting relative movement between the spacer (24) and the first positioning portion (2J) of the first substrate (2B), and/or wherein a positioning structure (24B, 2K1) is provided for restricting relative movement between the spacer (24) and the second positioning portion (2K) of the second substrate (2C).

8. The thermoelectric conversion module (2) according to claim 7, wherein the spacer (24) has a surface (24A, 24B) that is curved outward toward the first substrate (2B) or the second substrate (2C), wherein at least one of the first positioning portion (2H, 2J) and the second positioning portion (2L, 2K) has a contact portion (2J1, 2K1) that receives part of the curved surface (24A, 24B) in contact therewith, wherein the positioning structure (24A, 24B, 2J1, 2K1) has the curved surface (24A, 24B) and the contact portion (2J1, 2K1).

9. The thermoelectric conversion module (2) according to claim 8, wherein the spacer (24) is spherical in shape, wherein the contact portion (2J1, 2K1) is formed in an annular shape or has a plurality of elements arranged in an annular shape.

10. The thermoelectric conversion module (2) according to claim 5, wherein at least one of the first positioning portion (2H, 2J) and the second positioning portion (2L, 2K) is provided by plating or resist.
